# EUROPEAN PATENT SPECIFICATION

(11) **EP 1 101 837 B1**
(45) Date of publication and mention of the grant of the patent: **09.01.2008**
(21) Application number: 99830718.5
(22) Date of filing: 22.11.1999
(51) Int. Cl.: C23C 22/08, C23C 22/03, H01L 21/321, C23C 22/10

(54) **Moisture corrosion inhibitor layer for Al-alloy metallization layers for electronic devices and corresponding manufacturing method**
Korrosion durch Feuchtigkeit inhibierende Schicht für Metallisierungsschichten aus Al für elektronische Vorrichtungen und Verfahren zur Herstellung
Couche contre la corrosion par l'humidité pour des couches métallisées en alliage d'Al pour des dispositifs éléctroniques et procédé de fabrication

(43) Date of publication of application: 23.05.2001
(73) Proprietor: STMicroelectronics S.r.l., 20041 Agrate Brianza (Milano) (IT)
(72) Inventor: Curro', Giuseppe, 98166 Messina (IT); Scandurra, Antonino, 95125 Catania (IT)
(74) Representative: Botti, Mario

(56) References cited:
- EP-A- 0 357 219
- DE-A- 2 162 078
- DE-A- 2 749 294
- FR-A- 1 246 716
- FR-A- 2 312 117
- GB-A- 396 746
- US-A- 2 515 934
- US-A- 3 986 897
- US-A- 4 082 604
- PATENT ABSTRACTS OF JAPAN vol. 011, no. 190 (E-517), 18 June 1987 (1987-06-18) & JP 62 020351 A (NEC CORP), 28 January 1987 (1987-01-28)
- PATENT ABSTRACTS OF JAPAN vol. 012, no. 072 (E-588), 5 March 1988 (1988-03-05) & JP 62 213264 A (NEC CORP), 19 September 1987 (1987-09-19)

## Description

### Field of the Invention

This invention relates to a semiconductor integrated electronic/device, which includes an inhibitor layer for inhibiting moisture-generated corrosion of A1 alloy metallization layers and to a method of fabricating such a layer.

As is well known in this specific field, corrosion of the final metallization layer, mainly occurring when the electronic devices are assembled and encapsulated in plastics packages, represents a serious problem of reliability in the manufacture of semiconductor integrated electronic devices.

For example, the performance of power devices incorporating MOS power transistors is deeply affected by corrosion of the metal layer on the device face. This effect is the more strongly felt the smaller the dimensions of the integrated circuit.

A determining value for satisfactory operation of the device is its resistance in the power-on condition, and this value can be deeply altered by oxidation of the metal layer on the device face, which layer is, in power devices, coincident with the source electrode of the power MOS. Face metallizing is common practice in the semiconductor industry, and involves depositing a layer of an aluminum alloy, typically Al-Si (1% w/o), in all those devices for which electromigration is of no serious concern, such as in power switches using power MOSs.

The corrosive phenomenon in a damp environment can start at the surface of the Al-Si alloy whenever condensation water collects thereon, since water contains a sufficient concentration of corrosive ion impurities dissolved in it. Condensation water can also form locally on the metal layer surface, e.g. as a result of water penetrating the package and the molding protection resin during the tests for operability in moisture, occasionally carried out inside pressure cookers.

Certain ion species flowing between the cathodic and the anodic surface regions may be released from the molding resin itself, or may be contained as contaminants in the materials entering the construction of the integrated circuit. The molding resin, further to absorbing and possibly becoming saturated with water, can act somehow as an electrolitic medium, although the diffusion of ions and electrons through the resin layer meets with sufficient difficulty to retard and ultimately check the corrosive processes.

Finally, it should be noted that an electrolytic cell may form on the alloy layer surface. Its cathode and anode usually are two electrodes of the device, e.g. the gate and source metal contacts in a MOS power transistor, or may be the gold bonding wire and the surrounding surface of the Al metallization layer.

The Al metallization layer is normally coated with a very thin (a few tens Å) layer of native oxide hydrate which preserves the metal beneath from further corrosion in standard environmental conditions. However, this native layer becomes eroded where the condensed electrolyte contains a sufficient amount of catalytic agents. In this case, the Al oxide hydrate is dissolved by chemical reaction, which results in the surface of the Al metal layer being rapidly brought to contact the electrolyte and a galvanic corrosion mechanism being initiated in the Al layer through either of two possible reaction paths, according to the local pH value:
in an acidic medium,

   2Al + 6H⁺ → 2Al³⁺ + 3H₂

   2Al³⁺ + 6H₂O → 2Al(OH)₃ + 6H⁺
and in a basic medium,

   Al + 3OH → 2Al(OH)₃ + 3e⁻

   6O₂ + 6H₂O + 12e- → 120H⁻

### Prior Art

A first prior approach to making corrosion less likely to occur is based on forming a suitable inhibitor layer over the surface of the aluminum alloy layer.

For this inhibitor layer to be effective, the layer and the processes for forming it are to meet certain requirements:
(a) be consistent with the performance of the finished device;
(b) leave the chemio-physical characteristics of the other layers comprising the integrated circuit unaffected;
(c) be compatible with the subsequent steps of bonding the lead wires and packaging.

In plastics packaged devices, the aluminum metal layer surface is generally "protected" with a relatively thick layer of a passivating dielectric (SiN, Pvapox, SiON, etc.) which prevents water from migrating to the aluminum surface from the molding resin. In all events, the passivating dielectric must be conformed, e.g. by a photolithographic process and associated etch, in order to bond wires to the surface of the Al metal layer and produce the contacts.

In power devices, where large currents are involved, bonding wires of diameters in the 50.8 nm - 508 nm (2 to 20 mils) range are usually employed which require a relatively broad bonding area.

The bonding ends represent uncovered metal regions and, accordingly, are potentially subject to the corrosive action of water in either saturated steam or liquid form. It can be appreciated, therefore, that the passivation dielectric ordinarily employed cannot solve the problem in any conclusive way, and requires additional process steps (dielectric depositing, masking, etching) which introduce further problems from interaction with the underlying layers as well as added cost.

The technical problem underlying this invention is to provide a novel type of protection or passivation for the metal layers present in semiconductor integrated circuits, which exhibits appropriate structural and functional features to effectively protect the metal layer against corrosion, without burdening the electronic device manufacture with additional complexity and cost. In this way, the aforementioned drawbacks of the prior art can be overcome.

### Summary of the Invention

The concept behind this invention is one of growing, over the metal layer, a very thin passivating phosphate layer or film effective to resist corrosion/hydroxidation of the metal when the latter is subjected to stresses in a damp environment. This thin film is grown by chemical treatment of the Al alloy metal layer surface.

Based on this concept, the technical problem is solved by a method of producing a protective inhibitor layer as previously indicated and defined in the characterizing portion of Claim 1.

The invention also relates to a semiconductor integrated electronic device, which includes protective inhibitor layer as defined in Claim 7.

The features and advantages of the method and the inhibitor layer according to the invention will be apparent from the following description of embodiments thereof, given by way of non limitative example with reference to the accompanying drawings.

In the drawings:

### Brief Description of the Drawings

Figure 1A is an enlarged vertical cross-section view showing schematically a portion of a semiconductor electronic device subjected to a step of the inventive method.
Figure 1B shows schematically the substrate portion of Figure 1 at a subsequent step of the inventive method.
Figures 2 to 5 are XPS graphs or spectra illustrating schematically the results of test measurements, plotted as intensity vs. bonding energy for semiconductor electronic devices obtained in accordance with the inventive method.

### Detailed Description

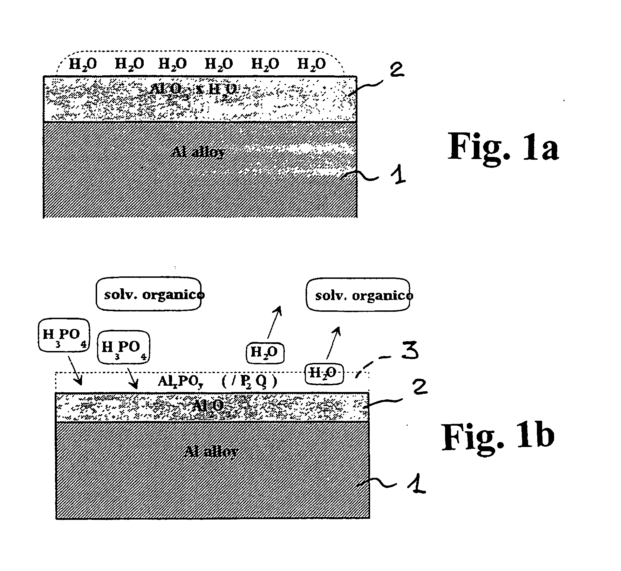

Referring to the drawing figures, in particular to Figure 1A, a metallization layer formed over a semiconductor electronic device, omitted from view because conventional, is generally shown schematically at 1. The metallization layer 1 may be an aluminum-silicon (Al-Si) alloy conventionally deposited as the final interconnection layer between electronic components integrated in a semiconductor integrated circuit.

The process steps and the structures described hereinafter do not describe a complete process for fabricating integrated circuits. The present invention, in fact, can be practiced concurrently with integrated circuit fabricating techniques presently employed in the industry, and only such process steps as are necessary to explain the invention will be discussed hereinafter.

Figures showing cross-sections through portions of an integrated circuit during its fabrication are not drawn to scale, but rather to highlight major features of the invention.

The semiconductor integrated circuit is formed on a semiconductor substrate being a part of a so-called semiconductor wafer. This substrate may be doped P+ or doped N+.

The semiconductor wafer has a face side surface which is still raw, since it is intended to receive the layout of a device or an electronic circuit integrated monolithically in the semiconductor.

The semiconductor wafer also has an underside surface, oppositely located from the face side surface. These face side and underside surfaces will also be referred to hereinafter as the front and the back of the semiconductor wafer.

Advantageously in the method of this invention, the surface of the Al alloy metal layer 1 is modified by application of a process step to the semiconductor wafer after completing the processing steps.

The wafer front is covered with the aluminum metal layer, while its back is deposited a metallization layer comprising plural layers (e.g., TiNiAu).

The method of this invention leaves the surface of the metal layer on the wafer back unaltered, or at least will not "degrade" it. Accordingly, it allows all of the subsequent processing steps, such as the die-attach process for bonding to the supporting frame used at the packaging stage, to be carried out as normal.

Advantageously in the method of this invention, a very thin phosphate layer or film 3 is provided which is effective to resist corrosion/hydroxidation of the metal as the latter undergoes stresses in a damp environment. Preferably, this thin film 3 is grown by a chemical surface treatment of the Al alloy metallization layer 1.

According to the invention, a treatment of the Al layer is provided which is effective to produce a very thin phosphatised passivating layer exhibiting an anti-corrosion property in a damp environment.

In essence, according to the method of this invention the wafer is treated with a mixture of a polar organic solvent, e.g. acetonitrile or ethyl acetate, and phosphoric acid or phosphate derivatives thereof, at a temperature in the 25 to 40°C range for a time between 5 and 40 minutes. The process sequence and details of the various steps are given herein below.

Step 1) Dipping the wafer in a mixture of polar organic solvent and 0.5 to 1% v/v phosphoric acid.
temperature -- 25 to 40°C;
time -- 5 to 40 minutes.

Step 2) Post-treatment ultrasonic washing in alcohol or water.

Step 3) Drying at a low temperature.

Before applying the treatment according to this method, the surface of the metallization layer 1 is coated with a thin (30 to 40Å) layer 2 of native oxide hydrate Al₂O₃.xH₂O. The chemical reactions that take place on this surface during the first step of the inventive method are illustrated by Figures 1A and 1B.

The aluminum surface, as coated with the thin phosphate film 3 during the previous process steps (1), (2) and (3), is further treated thermally under an N₂ medium at a temperature of 125° to 150°C for about 1 hour.

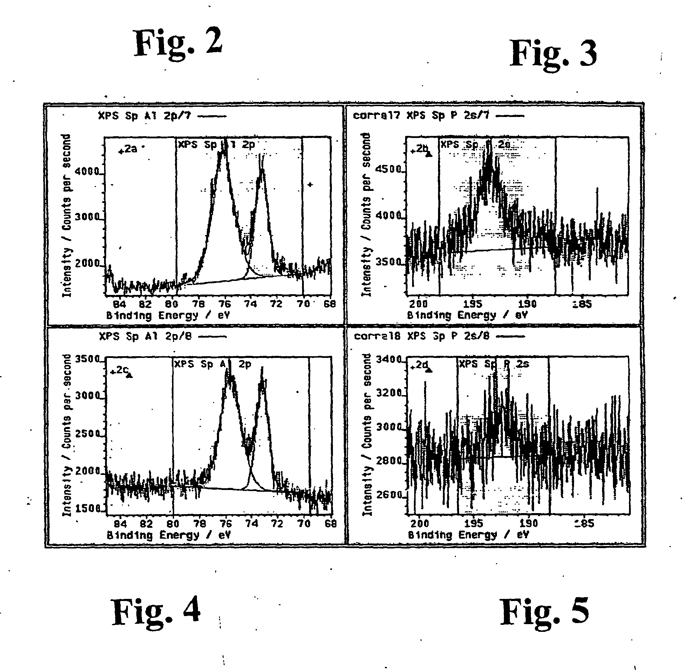

This additional step allows the phosphatised termination to be rebuilt by the formation of a layer of AlPO₄ precipitate, which is highly resistant to stress in hot steam. This conclusion is reached following an analysis of the XPS data presented on the respective graphs, discussed hereinafter with reference to Figures 2 to 5.

The last-mentioned thermal treatment results in the formation of a phosphate layer a few monolayers thick, either partly or fully cured. At this phosphate layer, the thickness of the dehydrated terminating alumina is less than the original one and attains a steady-state value which will depend on the treatment temperature. A possible process marker is provided by ESCA measures which characterize the surface chemistry in terms of both phosphorus content and thickness of the surface aluminum oxide. Figures 2 and 3 relate, for example, to the surface soon after growing the thin film 3 on the semiconductor wafer, and Figures 4 and 5 relate to results obtained by opening mechanically a previously packaged device in plastics of an epoxy resin.

More particularly, Figures 2 and 4 show the XPS spectrum for the aluminum, wherein the traces of the aluminum metal and the oxidised aluminum are to be seen. Figures 3 and 5 contain the phosphorus trace.

The method of this invention does solve the technical problem and offers several advantages, outstanding among which is the fact that the protective phosphate layer actually prevents corrosion of the underlying metallization layer when placed in a damp environment.

Furthermore, in the specific field of semiconductor integrated devices, the protective layer provided by the method of this invention enables direct bonding of the lead wires to the modified aluminum surface.

## Claims

1. A method of producing a protective inhibitor layer against moisture-generated corrosion for aluminum (Al) alloy metallization layers (1) in semiconductor electronic devices, **characterized in that** it comprises at least one step of dipping the electronic device in a mixture of a polar organic solvent and phosphoric acid (H₃PO₄) at a concentration comprised between 0.5 and 1% (v/v) and a thermal treatment under a nitrogen (N₂) atmosphere at a temperature of 125° to 150°C for about one hour.

2. A method according to Claim 1, **characterized in that** it comprises a further step of ultrasonic washing in alcohol or water.

3. A method according to Claim 1, **characterized in that** said at least one dipping step is carried out at a temperature of 25° to 40°C for 5 to 40 minutes.

4. A method according to Claim 1, **characterized in that** it further comprises a low-temperature drying step.

5. A method according to Claim 1, **characterized in that** it comprises a further thermal treatment.

6. A method according to Claim 1, **characterized in that** said polar organic solvent is acetonitrile or ethyl acetate.

7. A semiconductor integrated electronic device, which includes a protective inhibitor layer of moisture-generated corrosion for aluminum (Al) alloy metallization layers (1), comprising an aluminum phosphate (AlPO₄) obtainable through the method of any of the previous claims.

## Patentansprüche

1. Verfahren zur Herstellung einer schützenden Hemmschicht gegen durch Feuchtigkeit hervorgerufene Korrosion für Metallisierungsschichten (1) aus Aluminium (Al)-Legierung bei elektronischen Halbleitervorrichtungen, **dadurch gekennzeichnet, dass** es mindestens einen Schritt des Eintauchens der elektronischen Vorrichtung in ein Gemisch aus einem polaren organischen Lösungsmittel und Phosphorsäure (H₃PO₄) in einer Konzentration, die zwischen 0,5 und 1% (v/v) liegt, und eine Wärmebehandlung unter einer Stickstoff (N₂)-Atmosphäre bei einer Temperatur von 125° bis 150°C für etwa eine Stunde aufweist.

2. Verfahren nach Anspruch 1, **dadurch gekennzeichnet, dass** es einen weiteren Schritt des Ultraschallwaschens in Alkohol oder Wasser aufweist.

3. Verfahren nach Anspruch 1, **dadurch gekennzeichnet, dass** der mindestens eine Schritt des Eintauchens bei einer Temperatur von 25° bis 40°C fünf bis 40 Minuten lang durchgeführt wird.

4. Verfahren nach Anspruch 1, **dadurch gekennzeichnet, dass** es außerdem einen Tieftemperatur-Trocknungsschritt aufweist.

5. Verfahren nach Anspruch 1, **dadurch gekennzeichnet, dass** es eine weitere Wärmebehandlung aufweist.

6. Verfahren nach Anspruch 1, **dadurch gekennzeichnet, dass** das polare organische Lösungsmittel Acetonitril oder Ethylacetat ist.

7. Integrierte elektronische Halbleitervorrichtung, die eine schützende Hemmschicht gegen durch Feuchtigkeit hervorgerufene Korrosion für Metallisierungsschichten (1) aus Aluminium (Al)-Legierung, die ein Aluminiumphosphat (Al-PO₄) aufweist, die durch das Verfahren nach einem der vorangehenden Ansprüche erhältlich ist, enthält.

## Revendications

1. Procédé de fabrication d'une couche d'inhibition protectrice à l'encontre d'une corrosion générée par l'humidité de couches de métallisation (1) en alliage d'aluminium (A1) dans des dispositifs électroniques à semiconducteurs, **caractérisé** on ce qu'il comprend au moins une étape d'immersion du dispositif électronique dans un mélange de solvant polaire organique et d'acide phosphorique (H₃PO₄) à une concentration comprise entre 0,5 et 1 % en volume et un traitement thermique dans une atmosphère d'azote (N₂) à une température de 125° à 150°C pendant environ une heure.

2. Procédé selon la revendication 1, **caractérisé** eu ce qu'il comprend une étape supplémentaire de lavage aux ultrasons dans de l'alcool ou de l'eau.

3. Procédé selon la revendication 1, **caractérisé en ce que** ladite au moins une étape d'immersion est effectuée à une température de 25° à 40°C pendant 5 à 40 minutes.

4. Procédé selon la revendication 1, **caractérisé en ce qu'**il comprend en outre une étape de séchage à basse température.

5. Procédé selon la revendication 1, **caractérisé en ce qu'**il comprend un traitement thermique supplémentaire.

6. Procédé selon la revendication 1, **caractérisé en ce que** le solvant polaire organique est de l'acétonitrile ou de l'acétate d'éthyle.

7. Dispositif électronique intégré à semiconducteur qui comprend une couche d'inhibition protectrice contre la corrosion produite par l'humidité sur des couches de métallisation (1) en alliage d'aluminium (A1) comprenant un phosphate d'aluminum (AlPO₄) que l'on peut obtenir par le procédé selon l'une quelconque des revendications précédentes.
